# EUROPEAN PATENT SPECIFICATION

(11) **EP 1 953 794 B1**
(45) Date of publication and mention of the grant of the patent: **01.02.2012**
(21) Application number: 08005612.0
(22) Date of filing: 23.11.2005
(51) Int. Cl.: C23C 16/44, C23C 16/54

(54) **Vacuum processing chamber for very large area substrates**
Vakuumbehandlungskammer für sehr großflächige Substrate
Chambre de traitement sous vide pour les substrats de surface très large

(30) Priority: 24.11.2004 US 630667 P
(43) Date of publication of application: 06.08.2008
(62) Divisional of application: 05803234.3
(73) Proprietor: Oerlikon Solar AG, Trübbach, 9477 Trübbach (CH)
(72) Inventor: Aing, Phannara, 94400 Vitry Sur Seine (FR); Delaunay, Laurent, 76160 Saint Epinay (FR); Jost, Stephan, 9478 Azmoos (CH); Elyaakoubi, Mustapha, 91130 Ris Orangis (FR)

(56) References cited:
- US-A- 4 719 873
- US-A- 4 798 739
- US-A- 4 989 543
- US-A1- 2002 026 984
- PATENT ABSTRACTS OF JAPAN vol. 008, no. 172 (C-237), 9 August 1984 (1984-08-09) & JP 59 070766 A (NIPPON SHINKU GIJUTSU KK), 21 April 1984 (1984-04-21)

## Description

This invention relates to vacuum processing equipment for very large area substrates, especially a PECVD process chamber (respectively an inner reactor) with compensation means for the deviation from flatness.

### Background of the invention

The present invention relates to large area PECVD process chambers in general and to such chambers which themselves are enclosed again in a second surrounding vacuum chamber in particular.
Such "boxes within a box", (Plasma Box^{™}) are known in the art and described in US Patent No. 4,798,739. The major advantage of such "boxes within a box" is that a lower pressure may be maintained in the outer airtight chamber than within the inner reactor chamber such that a controlled gas flow may be maintained from the inner- to the outer chamber ("differential pumping"). A further advantage of such a "boxes within a box" system is that the inner chamber may be maintained at a constant process temperature of typically around 250-350°C (isothermal reactor). By thus being constantly held at process temperature, such an inner reactor allows for uniform temperature distribution and thus for uniform overall deposition rates. With the appearance of larger and larger substrates (over 2m x 2m) however, it becomes more and more difficult to keep the inner reactor substantially flat and consequently to be able to comply with the required production specifications and to load and unload the substrates.

Due to the aggressive nature of the chemical agents involved in PECVD, aluminum alloys are the economic material of choice: Aluminum is one of the few materials known to be able to resist the attack of the chemical agents used in PECVD processes, such as fluorine containing gasses and species. Unfortunately however, aluminum alloys tend to exhibit creep deformation at elevated temperatures and even creep resistant alloys cannot fully eliminate such deformation over time.

Any deformation and deviation from flatness of the reactor also causes non uniform deposition on the substrate, since the deposition rate is (among other factors) a function of the plasma gap - i.e. the distance between the top and bottom electrodes of the reactor.
Furthermore, in order to load and unload substrates, it is necessary to be able to open both the outside chamber and the inner reactor and access them through a load lock. Any such opening must again be quickly and reliably sealable in a gas tight manner for the actual deposition process in order to avoid leakage.

### Prior Art

In the PECVD reactors of the "boxes within a box" type known in the art (US 4,798,739), stainless steel bars known as "stiffeners" are used to suspend the inner reactors from the outer chamber. The inner reactors themselves (for example the reactors of the Unaxis KAI 1200 system) are machined from two gas tight near symmetrical halves which are opened merely for maintenance and not for loading /unloading purposes. For loading / unloading purposes, a slit is machined in a side wall of the inner reactor which may be opened and closed by a slit valve in a gas tight manner. A fork holding a substrate is introduced into the inner chamber through such a slit. Then the substrate is accommodated by a set of vertical pins. Upon retraction of the fork, these (lifting-) pins may be retracted vertically until the substrate rests in its designated position. The slit is then sealed by a slit valve known in the art.

### Disadvantages in Prior Art

The biggest disadvantage of the current reactor design is the side-slit/fork/pin-type of loading and unloading the substrates as described above. This requires a uniform inner height of the reactor to accommodate the fork and the pins. With very large substrate sizes however, the fork tends to bend under the combination of its own weight and the substrate weight. The used loading/unloading mechanism dictates an increasingly large inner height of the reactor and dictates a large slit height.
Simple stainless steel stiffeners, such as T- or H shaped bars as known in the art, cannot fully compensate the deformation and distortion of very large reactors, especially when these reactors reach side lengths of over two meters. Simple stiffeners would not only fail to provide a flat reactor at room temperature, but especially so at operating temperature, since even stainless steel tends to loose strength at elevated temperature. Simple stiffener solutions tend to sag under the weight of the reactor as well as under their own weight, at room temperature as well as at operating temperatures of about 300°C.
The aforementioned issues, resulting mainly from different form accuracy issues that must be faced when using large reactor sizes of more than 2 meter side length, ask for a new reactor design.
So far the inner reactor is conceived as a one-piece vacuum chamber in the prior art. The loading and unloading of the reactor is done through a side slit machined in a side wall. The new reactor design has to meet requirements of optimal height while processing the substrate and the aforementioned loading issue resulting from the loading fork being bent. These requirements are no longer fulfilled by the traditional reactor design. Additionally, the reactors achieve larger and larger dimensions and have to comply with increasing deformation and expansion issues.

### Summary of the invention

A plasma reactor for plasma enhanced chemical vapor deposition (PECVD) for treatment of large-size substrates according to the invention will comprise an outer airtight vacuum chamber (19) and at least one inner reactor enclosed in said outer vacuum chamber (19), wherein said reactor is divided in two parts, a reactor bottom (6) and a reactor top (2) ; said reactor bottom (6) being movable vertically to open said inner reactor and to start lifting pins (8) sticking out ; further comprising stiffeners (1) supporting reactor top (2) and/or reactor bottom (6), said stiffeners being connected to reactor top (2) and/or reactor bottom (6) via compensation spacers (4) with thicknesses chosen to compensate the thermal expansion during operation.

### Brief description of the drawings

Fig. 1 shows a reactor according to one embodiment of the invention in opened (1 a) and closed condition (1 b).
Fig 2 shows stiffeners in sideview (2a) and lengthwise (2b and 2c) at two different sections.
Fig. 3 shows a sealing plate used for sealingly closing a reactor according to the invention.
Fig. 4 shows an implementaion of an inventive sealing plate / sealing spacer combination.
Figur 5 is a detail of an end of a selaing plate
Figur 6 shows a suspender for an RF antenna according to a further embodiment of the invention.

### Detailed description of the invention

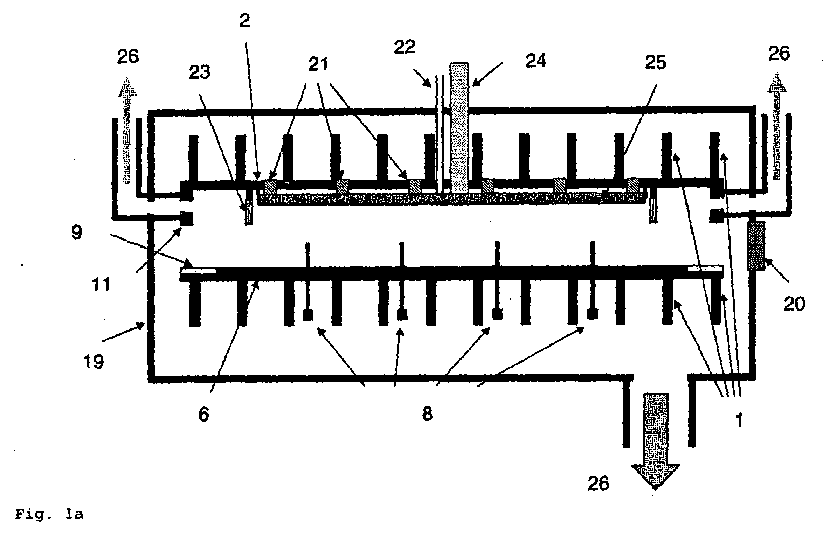

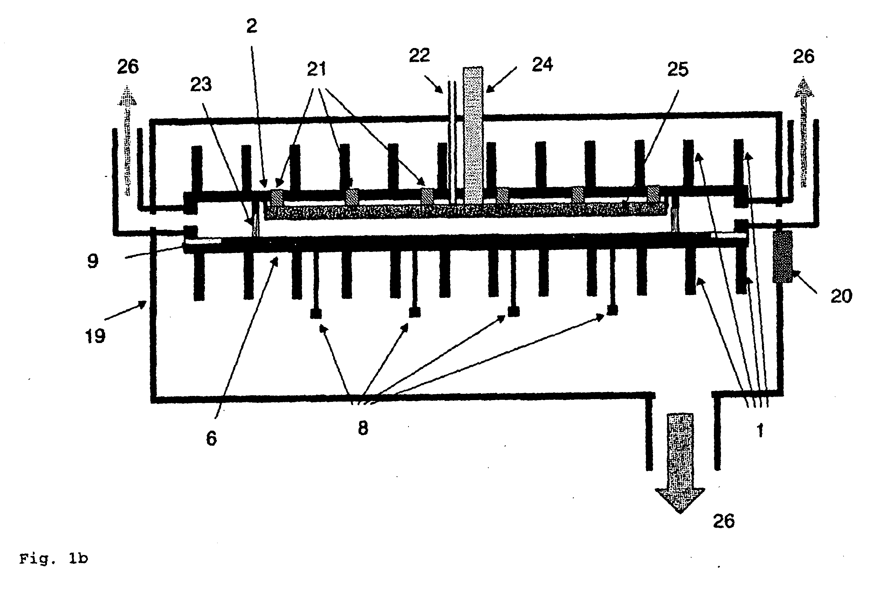

Therefore, the present invention is based on a new reactor concept. The reactor is divided in two parts; a reactor bottom 6 and a reactor top 2 (see Figure 1). The reactor top 2 is attached to the outer vacuum process chamber 19 preferably by stiffeners 1 (connection not shown in Figure 1). The reactor bottom 6 (or bottoms in the case of multiple reactor systems in a single outer chamber) is movable vertically such that a slit opens between the reactors side wall 11 and the sealing plate 9. When the reactor is fully opened the slit broadens and the lifting pins 8 start sticking out. The loading fork (not shown in Figure 1) is then able to deposit the substrate on the lifting pins for loading, or to retract the substrate from the lifting pins 8 by lifting the substrate from underneath through the chamber gate valve 20. This "inverted shoe box" type of opening has the major advantage that the height of the reactor walls 11 and thus accordingly the plasma gap can be relatively small. If a loading /unloading solution would be chosen by accommodating a slit valve (as opposed to the present invention and as is known in the art) in the reactor wall, the height of the wall 11 would have had to be massively increased to accommodate the entrance of a loading / unloading fork which may bend and vibrate with large substrates. Hence, an economic deposition process would be highly limited.

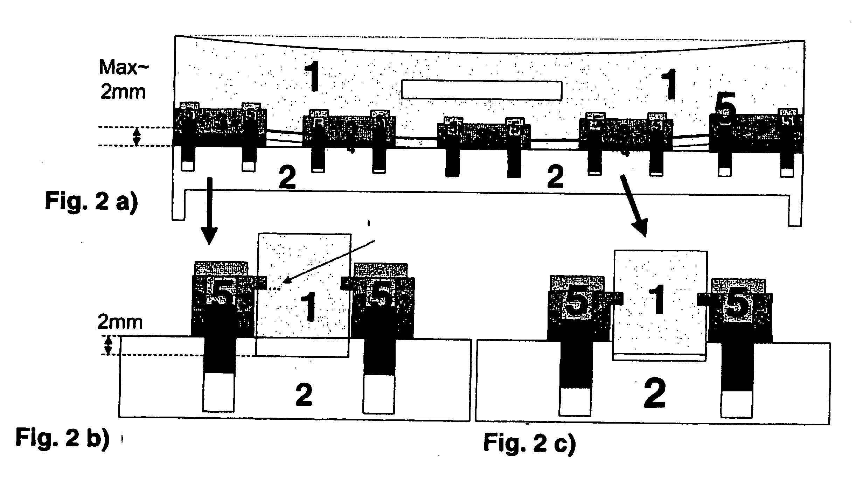

Beside the new reactor concept additional measures may be taken to assure the proper working of the plasma device. A further embodiment of the invention includes measures to compensate the deformation and expansion of the reactor that also result in sealing issues of the two-piece reactor. A first step to compensate for the deviation from flatness according to the present invention is the use of compensation spacers (Figure 2, reference 4).

Figure 2a-c illustrate how the sagging of the stiffeners 1 and thus of the reactor top 4 by gravity can be compensated for by compensation spacers 4. Screws 5 join reactor top 2 (e. g. made from an aluminum alloy) with stiffeners 1. Stiffener clips 3 engage e. g. with a groove machined into stiffener 1. Compensation spacers 4 of different thickness allow compensating the sagging of the stiffeners 1 during operation of the plasma reactor at elevated temperatures. The stiffeners 1 again are attached to cross plates at their ends (not shown). By using a reactor top stiffener 1 which is supported and attached to the outer chamber at the ends, and by carefully choosing the thickness of the compensation spacers 4, which are thicker at the ends of the stiffeners (Figure 2b), thinner towards the middle (Figure 2c) and absent in the center, sagging at operation temperature can be compensated for. The sagging of the reactor top needs to be more compensated in the middle than on the ends as illustrated by the curvature of the stiffener 1 in Figure 2a). Accordingly the stiffeners at the bottom (bottom side) of the reactor also show a slightly downwards curvature towards the center, but have the thickest compensation spacers in the center of the stiffener. The machined grooves in the stiffener 1 and in the stiffener clip 3 can further accommodate the thermal expansion between the reactor top and the stiffener.

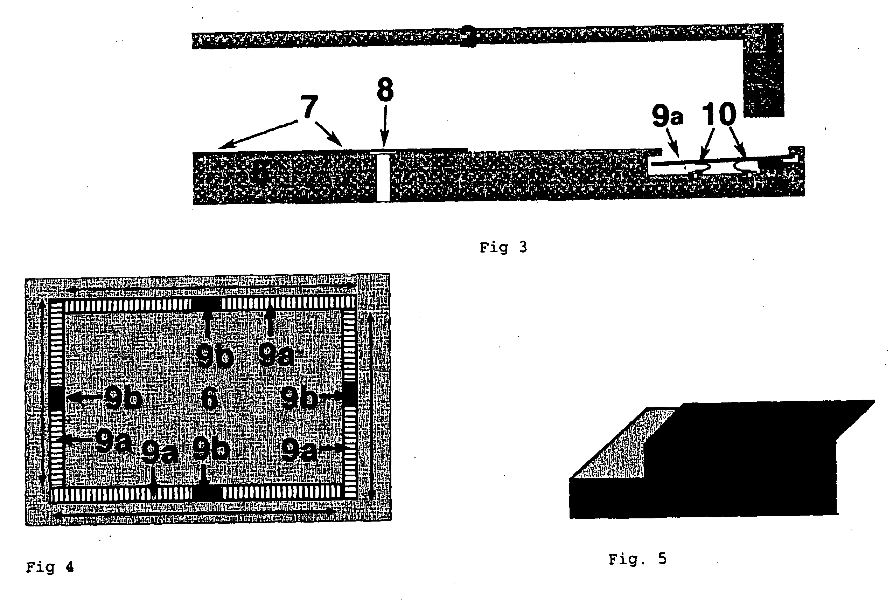

Figure 3 illustrates a further means of compensation from deviation of flatness: by employing a sealing plate 9a with plate springs 10. Further deviation from flatness of the reactor side wall 11 against the reactor bottom 6, which could not be compensated for by the stiffener compensation spacers, will negatively influence the gas tightness of the reactor. The sealing plate 9a is conceived to compensate for this deviation, since the plate 9a is elastic to some extent and is pressed to the reactor bottom 6 on the inner side of the reactor. Furthermore, a sealing spacer 9b under the center of the sealing plate (figure 4) serves to avoid that the sealing plate would be pinched over all the length between the reactor wall 11 and the reactor bottom 6. Thus the actual sealing is achieved in two places: between the sealing plate 9a and the reactor bottom on the inner side, and between the sealing plate 9a and the reactor wall 11 on the outer (top) side of the reactor.

The sealing spacers 9b offer a well defined close position, they enable the sealing plates 9a - which are fully pressed to the wall 11 by the plate spring 10 - to freely contract or expand away form the center. With a reactor side length of about 2.5 meters, a maximum distortion of about 2 mm can thus be compensated.

Since both the inner reactor and the outer vessel are under vacuum during operation, the sealing only needs to be gas tight to the pressure difference between both, which is typically in the range of 10⁻² to 10⁻³ mbar.

In Figure 4, the thin arrows illustrate how the thermal expansion of the sealing is accounted for. Generally, the sealing plate 9a is fixedly attached in the center and can contract and expand towards the corners.

Figure 5 illustrates a detail of the end of a seal plate 9a where it joins another seal plate 9a at a corner: a lip is provided to compensate thermal expansion.

In another, however less preferred embodiment, the sealing may alternatively be achieved by an elastic O-ring accommodated in a trapezoidal groove on the lower side (bottom) of the reactor wall 11. Since the reactor is intended to be opened and closed many thousand times, since the temperature in the reactor is high, and since the chemical species in the plasma are very aggressive, the material of such an O-ring is highly stressed. Today's materials for such an O-ring barely fulfill such requirements.

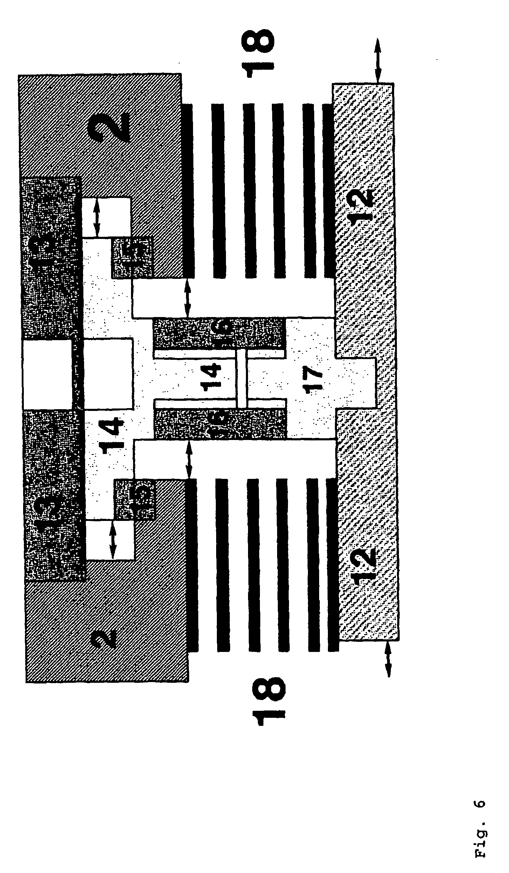

Figure 6 shows another part of the reactor where thermal expansion needs to be compensated for: the suspension of the radio - frequency (RF) antenna 12. Arrows in figure 6 indicate freedom to contract /expand. The suspenders hold the antenna in place; they do not feed the actual RF power. The RF power is fed through the antenna into the plasma which thereby considerably heats up and thermally expands accordingly. If the suspender were not used in a plasma reactor, the expansion / contraction problem could be readily solved by adding a dilatation groove as shown with the arrows between the reactor top 2 (grounded) and the suspender 14, and then electrically isolating the reactor top from the antenna by employing isolating ceramics on an appropriate part of the suspender. Since the reactor is operated under vacuum however, gaps and large potential drops must be avoided in order to avoid the ignition of parasitic plasma. Since in this case a gap between the reactor top 2 and the suspender 14 cannot be avoided because of the thermal expansion / contraction, a potential drop is avoided by bringing the top part 14 of the suspender to the same potential as the reactor top 2, by isolating the lower part 17 of the suspender (which has the same potential as the RF- antenna 12) by means of a ceramics cylinder (middle part, 16), which has a thread on the inside to attach the top 14 and the bottom 17 part of the suspender to each other. The top 14 and the bottom 17 part of the suspender are additionally separated by a small gap, which is too small to be susceptible to parasitic plasma. Additionally, RF spacers 18, with a floating potential are employed over the antenna to avoid parasitic plasma in the space between the reactor top 2 and the antenna 12.
In another, less preferred embodiment, the equivalent of the ceramic part in the middle of the suspender is a ceramic cylinder with two screw threads protruding at its ends. Screws in ceramic however are prone to break easily.

### Advantages of the invention

The reactor according to the present invention is intended for very large substrate sizes (such as substrates for liquid crystal displays) and for use in a outer vacuum chamber (like a Plasma Box^{™}). Due to its large size - thermal expansion (which can be in the range of centimeters with reactor lengths in the range of meters) and general deformation (such as creep deformation) - pose severe problems to gas tightness and to suspensions of the elements which have to be attached to the outer chamber. The major advantage of the present invention is that the reactor is gas tight from ambient temperature up to operating temperature (about 300°C). Another major advantage is that by using the "inverted shoebox" opening principle of the reactor, large slits in the reactor wall (as known in the art) can be avoided and thus the plasma gap can be kept small, which is essential to the productivity of the reactor.
The reactor acoording to the present invention is thus efficient, cheap, easy to manufacture and to maintain.

### References used in the figures:

- 1: Stiffener (e. g. from stainless steel)
- 2: reactor top (e. g. from aluminum alloy)
- 3: stiffener clip
- 4: compensation spacer
- 5: screw
- 6: reactor bottom
- 7: substrate
- 8: (lifting) pin for substrate support
- 9: 9a sealing plate
9b sealing spacer
- 10: Plate spring
- 11: (reactor) side wall
- 12: RF antenna (e. g. from aluminum)
- 13: Suspension lid
- 14: Suspender top (e. g. from aluminum)
- 15: Friction and particle reducing rings (e. g. from ceramics)
- 16: Suspender middle (e. g. from ceramics)
- 17: Suspender bottom (e. g. from aluminum)
- 18: RF spacers
- 19: Vacuum process chamber
- 20: Chamber valve gate
- 21: Suspender
- 22: Process gas feed
- 23: Pumping grid
- 24: RF feed
- 25: Electrode showerhead
- 26: Exhaust

## Claims

1. A plasma reactor for plasma enhanced chemical vapor deposition (PECVD) for treatment of large-size substrates, comprising an outer airtight vacuum chamber (19) and at least one inner reactor enclosed in said outer vacuum chamber (19), said reactor is divided in two parts, a reactor bottom (6) and a reactor top (2); said reactor bottom (6) being movable vertically to open said inner reactor and to start lifting pins (8) sticking out; further comprising stiffeners (1) supporting reactor top (2) and/or reactor bottom (6), said stiffeners being connected to reactor top (2) and/or reactor bottom (6) via compensation spacers (4) with thicknesses chosen to compensate the thermal expansion during operation.

2. The plasma reactor according to claim 1, wherein the compensation spacers (4) used for the stiffener (1) of the reactor top (2) are thicker at the end and thinner towards the middle of the stiffener (1).

3. The plasma reactor according to claim 1, wherein the compensation spacers (4) used for the stiffener (1) of the reactor bottom (6) are thickest in the center of the stiffener (1).

4. The plasma reactor according to claims 2- 3, wherein screws (5) join stiffener (1) and reactor top (2) or reactor bottom (6) respectively, with the aid of stiffener clips (3) and compensation spacer (4).

## Patentansprüche

1. Ein Plasmareaktor für plasmaunterstützte chemische Gasphasenabscheidung (PECVD) für die Behandlung von großflächigen Substraten, umfassend eine äußere luftdichte Vakuumkammer (19) und wenigstens einen in die genannte äußere Vakuumkammer (19) eingeschlossenen inneren Reaktor, wobei der genannte Reaktor in zwei Teile unterteilt ist, nämlich in ein Reaktorunterteil (6) und ein Reaktoroberteil (2); das genannte Reaktoroberteil (6) kann vertikal bewegt werden um den genannten inneren Reaktor zu öffnen und um herausstehende Aufnahmedorne (8) zu aktivieren; weiter umfassend das Reaktoroberteil (2) und/oder das Reaktorunterteil (6) stützende Versteifungen (1), wobei die genannten Versteifungen über Ausgleichsdistanzringe (4) mit einer Stärke, die passend für das Ausgleichen der Wärmeausdehnung während des Betriebs ausgewählt werden, mit dem Reaktoroberteil (2) und/oder dem Reaktorunterteil (6) verbunden sind.

2. Der Plasmaeraktor nach Anspruch 1, wobei die für die Versteifungen (1) des Reaktoroberteils (2) verwendeten Ausgleichsdistanzringe (4) an ihren Ende dicker sind und nach der Mitte der Versteifungen (1) hin dünner sind.

3. Der Plasmareaktor nach Anspruch 1, wobei die für die Versteifungen (1) des Reaktorunterteils (6) verwendeten Ausgleichsdistanzringe (4) in der Mitte der Versteifungen (1) am dicksten sind.

4. Der Plasmareaktor nach Ansprüchen 2 - 3, wobei Schrauben (5) die Versteifungen (1) mithilfe von Versteifungsklemmen (3) und Ausgleichsdistanzringen (4) mit dem jeweiligen Reaktoroberteil (2) oder dem Reaktorunterteil (6) verbinden.

## Revendications

1. Réacteur à plasma pour dépôt chimique en phase vapeur assisté par plasma (PECVD) pour traiter des substrats de grande taille, comprenant une chambre externe (19) sous vide étanche à l'air et au moins un réacteur interne enceint dans ladite chambre externe (19) sous vide, ledit réacteur étant divisé en deux parties : un bas (6) de réacteur et un haut (2) de réacteur, ledit bas (6) de réacteur étant mobile verticalement pour ouvrir ledit réacteur interne et faire sortir des axes (8) de levage ; comprenant en outre des raidisseurs (1) soutenant le haut (2) de réacteur et/ou le bas (6) de réacteur, lesdits raidisseurs étant reliés au haut (2) de réacteur et/ou au bas (6) de réacteur par des entretoises compensatrices (4) d'une épaisseur choisie pour compenser la dilatation thermique en service.

2. Réacteur à plasma selon la revendication 1 dans lequel, les entretoises compensatrices (4) utilisées pour le raidisseur (1) du haut (2) de réacteur sont plus épaisses à leur extrémité et plus minces vers le milieu du raidisseur (1).

3. Réacteur à plasma selon la revendication 1 dans lequel, les entretoises compensatrices (4) utilisées pour le raidisseur (1) du bas (6) de réacteur sont les plus épaisses au centre du raidisseur (1).

4. Réacteur à plasma selon les revendications 2 à 3 dans lequel, des vis relient respectivement le raidisseur (1) et le haut (2) de réacteur ou bas (6) de réacteur à l'aide de clips raidisseurs (3) et d'une entretoise compensatrice (4).
